# EUROPEAN PATENT SPECIFICATION

(11) **EP 2 325 846 B1**
(45) Date of publication and mention of the grant of the patent: **28.10.2015**
(21) Application number: 10190245.0
(22) Date of filing: 05.11.2010
(51) Int. Cl.: B82Y 25/00, G11C 11/16, H01F 10/32, H01L 43/08

(54) **A magnetic tunnel junction memory with thermally assisted writing**
Speicher mit einer magnetischen Tunnelübergangsanordnung und wärmeunterstütztem Schreibverfahren
Mémoire jonction tunnel magnétique dotée d'une procédure d'écriture thermiquement assistée

(30) Priority: 12.11.2009 US 260527 P
(43) Date of publication of application: 25.05.2011
(73) Proprietor: Crocus Technology S.A., 38025 Grenoble Cedex (FR)
(72) Inventor: Reid, Jason, San Jose, CA 95118 (US)
(74) Representative: P&TS SA (AG, Ltd.)

(56) References cited:
- WO-A1-2009/115505
- US-A1- 2007 263 434
- US-B2- 7 411 817
- VOVK A YA ET AL: "Magneto-transport properties of CoFe-Al2O3 granular films in the vicinity of the percolation threshold", JOURNAL OF MAGNETISM AND MAGNETIC MATERIALS, ELSEVIER SCIENCE PUBLISHERS, AMSTERDAM, NL, vol. 242-245, 1 April 2002 (2002-04-01), pages 476-478, XP004358731, ISSN: 0304-8853, DOI: DOI:10.1016/S0304-8853(01)01061-7
- VOVK A YA ET AL: "Tunneling magnetoresistance in granular cermet films with particle size distribution", JOURNAL OF MAGNETISM AND MAGNETIC MATERIALS, ELSEVIER SCIENCE PUBLISHERS, AMSTERDAM, NL, vol. 272-276, 1 May 2004 (2004-05-01), pages E1403-E1405, XP004513911, ISSN: 0304-8853, DOI: DOI:10.1016/J.JMMM.2003.12.902
- VOVK ANDRIY YA ET AL: "Room temperature tunneling magnetoresistance of electron beam deposited (Co50Fe50)x(Al2O3)1-x cermet granular films", JOURNAL OF APPLIED PHYSICS, AMERICAN INSTITUTE OF PHYSICS. NEW YORK, US, vol. 91, no. 12, 15 June 2002 (2002-06-15) , pages 10017-10021, XP012055408, ISSN: 0021-8979, DOI: DOI:10.1063/1.1480113

## Description

### Reference data

This application claims priority to United States provisional patent application, Serial No. 61/260,527, filed on November 12, 2009. Priority to the provisional application is expressly claimed.

### Technical field of the disclosure

The technical field of this disclosure relates to the art of magnetic tunnel junction structures; and particularly, to thermally-assisted magnetic tunnel junction structures; and more particularly to thermally-assisted magnetic tunnel junction structures used as memories capable of storing digital and/or analog signals.

### Background of the disclosure

A magnetic tunnel junction structure comprises two magnetic thin-films separated by an ultra-thin layer of insulator. The insulating layer is sufficiently thin, typically with a thickness of around 1 nanometer, such that electrons can tunnel through the insulating layer (also referred to as tunnel barrier) if a bias voltage is applied across the two magnetic thin-films. The tunneling current depends upon the relative orientation of magnetizations of the two magnetic thin-films, while the orientation can be altered by an applied magnetic field.

Extensive interest exists in magnetic tunnel junction structures due to their usefulness in both industrial application and scientific research. In particular, significant studies have been undertaken on the application of magnetic tunnel junction structures for storage (*e.g*. digital signal memories) and sensors (*e.g*. analog signal sensors).

Thermally-assisted magnetic tunnel junction structure is a type of magnetic tunnel junction structure. A thermally-assisted magnetic tunnel junction layer employs an electrically conducting, but thermally-resistive thin-film (henceforce known as the "thermal film") in the structure to achieve of the Curie temperature in one of the magnetic layers using with minimized electric heating current during operation, an example of which is set forth in US patent 7,411,817 to Nozières et al., issued August 12, 2008.

For the purpose of achieving a Curie temperature for a magnetic layer within the device, a thermal layer in a thermally-assisted magnetic tunnel junction structure is desired to have a high electric conductivity and a low thermal conductivity, e.g. with respect to transition metals. Existing thermally-assisted magnetic tunnel junction structures can use chalcogenide-based materials, such as Ge-Sb-Te alloys. Integration of such materials however is difficult due to deleterious thermal and mechanical properties as well as the unusual ease in which the material etches in fabrication.

In US patent application US2007/0263434 to Dieny et al., discloses a thermally-assisted magnetic tunnel junction device comprising a magnetic tunnel junction formed from a magnetic reference layer, a tunnel barrier, and a magnetic storage layer storage layer. The magnetic tunnel junction further comprises an intermediate layer constituted of a first thermal barrier formed by a material having a thermal conductivity lower than 5 W/m°C such that the storage layer can be heated efficiently while minimizing the electric power necessary for this heating. This document discloses the preamble of claim 1.

### Summary

In view of the foregoing, disclosed herein is a thermal layer for use in thermally-assisted magnetic tunnel junction structures, especially in thermally-assisted magnetic tunnel junction structures for use as memories.

A magnetic-random-access memory device of the invention is defined by claim 1.

In an embodiment, a thermally-assisted magnetic tunnel junction structure is disclosed herein. The magnetic-random-access memory device can comprise: a magnetic tunnel junction comprising a tunnel junction layer positioned between first and second magnetic layers; and a thermal barrier layer that comprises a material having XₐY_{b}Z_{c}, wherein X is a transition metal, Y is selected from column IIIA or IVA in the periodic table; and wherein Z is selected from column VA or VIA in the periodic table.

In another embodiment, a thermally-assisted magnetic-random-access memory device can comprise: a magnetic tunnel junction comprising a tunnel junction layer positioned between a free magnetic layer and a fixed magnetic layer; and a thermal barrier pining the free magnetic layer below a temperature threshold and acting as a paramagnet at and above the temperature threshold when the thermal barrier is heated; wherein the thermal barrier comprises a cermet material that is comprised of a ceramic and a metallic component.

In yet another embodiment, the cermet material can be comprised of XₐY_{b}Z_{c}, wherein X is a transition metal, Y is selected from column IIIA or IVA in the periodic table; and wherein Z is selected from column VA or VIA in the periodic table.

In yet another embodiment, the cermet material can comprise a matrix base material with an interspersing material interspersed within or at a surface of the matrix base material.

In yet another embodiment, the interspersing material can be comprised of a transition metal.

In yet another embodiment, the matrix base material can be comprised of a binary compound *Y-Z*, wherein *Y* is selected from groups 3A to 6A of the periodic table and *Z* is N; or can be comprised of a ternary material *X-Y-Z,* where *X* is a transition metal; *Y* is Si, Al, or B; and *Z* is nitride or O-N, or C-N, or P-N.

In yet another embodiment, the thermal barrier can have a thermal conductivity 3W/mK or less and an electric resistivity of 200 µm-cm or more at a temperature of 20°C.

In yet another embodiment, the thermal barrier can have a thermal conductivity of 3 W/mK or less.

In another embodiment, the thermal barrier can be comprised of a varistor having a non-linear current-voltage property.

In yet another embodiment, the metallic component of the cermet material can have a long-range order that is 200 angstroms or 100 angstroms or less in the thermal barrier.

In yet another embodiment, the thermal barrier can have an electrical conductivity of from 1×10⁴ S/m to 60×10⁴ S/m at a temperature of 20°C.

The present disclosure also pertains to a magnetic memory system comprising a plurality of the thermally-assisted magnetic-random-access memory device.

The thermally-assisted magnetic tunnel junction structure disclosed herein has shorter heating and cooling temperatures and thus can be switched faster than conventional magnetic tunnel junction structures. The disclosed thermal barrier is more compatible with standard semiconductor fabrication processes than are existing chalcogenide materials used in conventional thermal barriers.

### Brief Description of the Drawings

The invention will be better understood with the aid of the description of an embodiment given by way of example and illustrated by the figures, in which:
FIG. 1 diagrammatically illustrates an exemplary thermally-assisted magnetic tunnel junction structure;
FIG. 2 diagrammatically illustrates an exemplary thermal layer used in the thermally-assisted magnetic tunnel junction structure in FIG. 1;
FIG. 3 diagrammatically illustrates an exemplary free magnetic layer used in the thermally-assisted magnetic tunnel junction structure in FIG. 1; and
FIG. 4 diagrammatically illustrates an exemplary fixed magnetic layer used in the thermally-assisted magnetic tunnel junction structure in FIG. 1.

### Detailed Description of possible embodiments

Disclosed herein is a thermally-assisted magnetic tunneling junction structure having a magnetic tunnel junction and at least a thermal barrier. The thermal barrier comprises a varistor that exhibits a non-linear I-V (current-voltage) property, wherein the varistor in one example is a cermet that is composed of ceramic and metallic materials. The thermal barrier is preferably configured such that it exhibits a measurable negative thermal coefficient of resistivity (TCR). The thermal barrier is preferably a disordered structure that is composed of one or more electrically conductive components (hereafter conductive component or components) and one or more electrically insulating or dielectric components (hereafter dielectric component or components). The one or more electrically conductive component are preferably randomly or disorderedly distributed or embedded within a matrix of the one or more dielectric components. As a consequence, the thermal barrier exhibits low thermal conductivity (e.g. lower than the thermal conductivity of many chalcogenide materials (e.g. Ge-Sb-Te), or equal to or lower than 3.0 W/m.K, such as equal to or lower than 2.0 Wm⁻¹K⁻¹) and a high conductivity (e.g. equal to or higher than that of chalcogenide materials (e.g. Ge-Sb-Te)). Meanwhile, the thermal barrier can be much more compatible with standard semiconductor fabrication processes than existing chalcogenide materials when, for example, the thermal barrier is comprised of a cermet.

The thermally-assisted magnetic tunnel junction structure will be discussed in the following with selected examples. It will be appreciated by those skilled in the art that the following discussion is for demonstration purposes and should not be interpreted as a limitation. Other variations within the scope of this disclosure are also applicable.

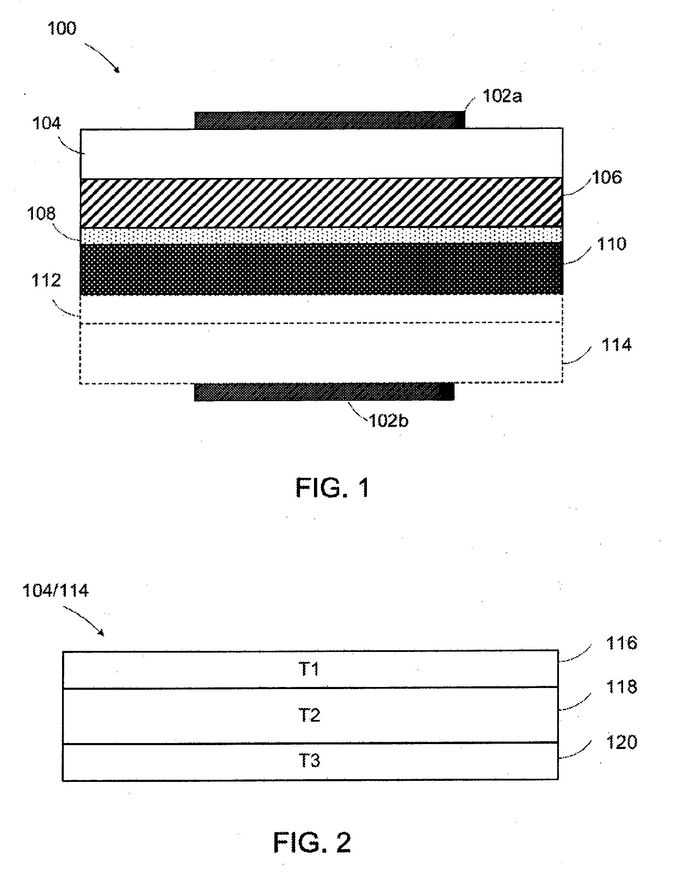

Referring to the drawings, FIG. 1 diagrammatically illustrates an exemplary thermally-assisted magnetic tunnel junction structure. In this example, thermally-assisted magnetic tunnel junction structure 100 comprises a magnetic tunnel junction that is comprised of free-magnetic layer 106, fixed-magnetic layer 110, and dielectric thin-film 108 positioned between the free-magnetic layer and fixed-magnetic layer. Thermal barrier 104 is provided for enabling the free-magnetic layer (106) to be at a temperature necessary for reorientating the magnetization orientation of the free-magnetic layer with a reduced current during operation, such as a temperature substantially equal to or higher than the Curie temperature at the free-magnetic layer during operation. In the example as diagrammatically illustrated in FIG. 1, thermal barrier layer 104 is positioned and in contact with free magnetic layer 106. In other examples, thermal barrier layer can be placed at other locations. For example, thermal barrier layer 104 can be placed such that other functional members, such as electrode 102a, can be positioned between thermal barrier layer 104 and free magnetic layer 106.

The magnetic tunnel junction structure (which comprises free magnetic layer 106, dielectric layer 108, fixed magnetic layer 110, and thermal barrier layer 104) may comprise other features depending upon the desired functions. For example, another barrier layer 114 can be provided to be placed on the bottom of fixed magnetic layer 110 for preventing heat leakage from the fixed magnetic layer. Buffer layer 112 can also be provided despite the bottom thermal layer 114. Bottom electrode 102b can be positioned for electrical connection. As thermal barrier layer 104, bottom thermal layer 114 can also be placed at any desired locations but on the opposite side of the magnetic tunnel junction. For example, bottom thermal layer can be placed such that other functional components, such as the buffer layer and/or the bottom electrode 102b can be positioned between the fixed magnetic layer 110 and the bottom thermal layer 114.

Each one or both of the thermal barrier layers (104 and 114) is preferably comprised of a varistor that exhibits a non-linear I-V property. Thermal barrier layer 104 comprises a cermet that is composed of ceramic and metallic materials. The thermal barrier is preferably configured such that it exhibits a measurable negative thermal coefficient of resistivity (TCR). In a linear example, the TCR can be expressed as Δ***R***/***R₀*** = αΔ***T***, wherein *R* is the resistivity; ***R₀*** is the reference resistivity; Δ***R*** is the change of the resistivity due to the change of temperature Δ***T***. a is the TCR, which is negative.

The thermal barrier is preferably a disordered structure that is composed of one or more conductive components and one or more dielectric components. The conductive component is preferably randomly or disorderedly distributed or embedded within a matrix of the dielectric component. As an example wherein thermal barrier layer 104 is comprised of one type of conductive elements, such as a specific type of transition metal, the conductive elements can be randomly or disorderedly distributed in a dielectric matrix with a long range order (*e.g*. along the maximum dimension of the thermal barrier such as length) that is 500 angstroms or less, such as 400 angstroms or less, 200 angstroms or less, 100 angstroms or less, 80 angstroms or less, 70 angstroms or less, 50 angstroms or less, 30 angstroms or less, or 20 angstroms or less. In other examples wherein multiple types of conductive elements are present distributed in a matrix of thermal barrier 104, the conductive elements are preferably randomly or disorderedly distributed such that conductive elements of the same type have a long range order that is 500 angstroms or less, such as 400 angstroms or less, 200 angstroms or less, 100 angstroms or less, 80 angstroms or less, 70 angstroms or less, 50 angstroms or less, 30 angstroms or less, or 20 angstroms or less.

The disordered structure can be amorphous, glass, nanostructure, or a combination thereof, such as disordered matrices. Exemplary disordered matrices can be matrix materials and nano-matrices. A matrix material is composed of islands of materials interspersed in or at a surface of a base material. For example, a matrix material may be comprised of islands of dielectric or conductive materials disorderedly or periodically positioned in the body or at a surface of, preferably, a disordered base of a material. The islands can be of any phases, such as crystalline, amorphous, glass, or clusters with transition regions. A nano-matrix is composed of a material base, within which nanoparticles are positioned. In one example, the material base may comprise vacancies within the body of the base material; and nanoparticles are positioned within the vacancies. In another example, nanoparticles are embedded within the body of the base material. In either example, the nanoparticles and the base material each can be dielectric and conductive materials.

Regardless of different structures and compositions, the thermal barrier exhibits low thermal conductivity and high electric conductivity. Specifically, the thermal barrier has a thermal conductivity that is preferably from 1.0 W/m.K to 3.0 W/m.K, and more preferably from 1.0 W/m.K to 2.0 W/m.K. In another example, the thermal barrier layer may have a thermal conductivity that is equal to or less than 3.0 W/m.K, such as 2.0 W/m.K or less, 1.0 W/m.K or less, 0.5 W/mK or less, 0.47 W/mK or less, 0.28 W/mK or less, 0.27 W/mK or less, 0.15 W/mK or less, and more preferably from 0.05 W/mK to 1.5 W/mK, and more preferably from 0.14 W/mK to 0.27 W/mK, or from 0.28 W/mK to 0.4 7W/mK.

The thermal barrier preferably, though not required, has a heating or cooling time of 10 ns or less, such as 5 ns. The heating time in a thermally-assisted MRAM cell is referred to as time for raising the temperature of a pin layer (*e.g*. thermal barrier layer 104 in FIG. 1, which is also referred to as a pin layer) to a threshold temperature, such as its Neel temperature or blocking temperature. It is understood that a pin layer, such as thermal barrier layer 104 in FIG. 1, in a thermally-assisted MRAM is an anti-ferromagnetic layer and is thus used to pin the magnetization orientation of magnetic free layer, such as layer 106 in FIG. 1, to its existing magnetization orientation. The pining of the free magnetic layer helps to stabilize the state of the MTJ junction of the MRAM cell. However, it also makes it more difficult to overcome the coercivity of the free magnetic layer (*e.g*. layer 106 in FIG. 1) in order to switch its magnetization orientation. Accordingly, the pin layer (*e.g*. thermal barrier layer 104) is heated via an electrical current. The current flowing through the pin layer is of sufficient magnitude to increase the temperature of the pin layer equal to or above a certain threshold, *e.g.*, its Neel temperature or blocking temperature, at which point pin layer (*e.g*. thermal barrier layer 104) acts as a paramagnet. As a consequence, pin layer (thermal barrier layer 104) will no longer pin free magnetic layer 106 to its existing state; and a lower magnetic field can be sufficient and used to switch the magnetization orientation of free magnetic layer 106. After the updating the magnetization orientation of the free magnetic layer (106), the temperature of the pin layer (*e.g*. thermal barrier layer 104 in FIG. 1) is lowered to below its Neel temperature or the blocking temperature so as to pin the updated magnetization orientation of the free magnetic layer 106. The time duration for such temperature-lowering process (*e.g*. to the room temperature) is referred to as the cooling temperature or annealing temperature. Shorter heating and cooling temperatures are desired as the shorter the heating and/or cooling temperature the faster the MTJ junction switches its state, and thus, the faster the MRAM cell operates. In another example, the thermal barrier has a thermal conductivity that is substantially equal to or less than that of a Ge-Sb-Te thin-film layer with substantially the same thickness and operation condition as the thermal barrier.

In order to pass through electrons, such as from an electrode (*e.g*. the top or the bottom electrode) to the free-magnetic layer (or the fixed magnetic layer), the thermal barrier is expected to be electrically conductive. Specifically, it is preferred that the thermal barrier exhibits an electrical conductivity of from 1x10⁴ S/m to 60×10⁴ S/m at temperature of 20°C; and more preferably from 1x10⁴ S/m to 10×10⁴ S/m at temperature of 20°C. Of course, the thermal barrier layer may have other electrical conductivities depends upon its specific structure and material. In one example, the thermal barrier layer may have an electrical conductivity of 1x10⁴ S/m or higher, such as 10×10⁴ S/m or higher or 60×10⁴ S/m or higher at temperature of 20°C. In another example, the thermal barrier has a thermal conductivity of 3 W/mK or less and an electric resistivity of 200 µm-cm or more at a temperature of 20°C. The thermal barrier more preferably has a thermal conductivity of 2 W/mK or less at temperature of 20°C; and/or an electric resistivity of 1000 µm-cm or more at temperature 20°C. In another example, the thermal barrier has an electrical conductivity equal to or larger than that of a Ge-Sb-Te thin-film layer with substantially the same dimensions and operation condition as the thermal barrier.

The coexistence of both low thermal conductivity and sufficient electrical conductivity in thermal barrier can be achieved by forming the thermal barrier by a varistor, such as a cermet material. A wide range of cermet materials can be used for the thermal barrier. In one example, the cermet may be comprised of transition metal nitrides, transition metal oxides, transition metal silicon-nitrides, transition metal boron-nitrides, or silicon-oxides of Ir, Ru, Re, Pd, Pt, or Rh, or any combinations thereof. In another example, the cermet may be comprised of chalcogenides or metal-aluminum-nitrides or noble metal-aluminum-nitrides. As used herein, transition metals are those elements in the periodic table in columns 3 to 12 (1 B to 8B), namely columns beginning with Sc, Ti, V, Cr, Mn, Fe, Co, Ni, Cu and Zn. Early transition metals are those elements in the periodic table in columns 3B, 4B, 5B, 6B and 7B; and late transition metals are those elements in columns 8B, 1 B and 2B. As used herein, "nitride" includes oxynitrides and carbonitrides, though preferably the additional oxygen or carbon is present, preferably in an amount of 10 atomic % or less. Noble metals are those elements as Ru, Rh, Pd, Ag, Os, Ir, Pt or Au, and the ferromagnetic transition metals are Fe, Co or Ni.

In another example, the thermal barrier is comprised of a cermet that is a matrix material. Specifically, the matrix cermet is comprised of a matrix base with interspersing particles (or islands or bubbles or other forms) interspersed within or at a surface of the matrix base. The matrix base may be a binary compound Y-Z, where Y is selected from groups 3A to 6A of the periodic table (*e.g*. Al, B and/or Si), and Z is N. In this way, the matrix material is preferably a nitride of silicon, aluminum or boron. The interspersed particles may be metallic materials that preferably comprise a transition metal (preferably from groups 8B or 1 B of the periodic table) that is preferably (though not required) not bound to nitrogen. The matrix base can alternatively comprised of SiOₓ (or BOₓ, POₓ, COₓ; or AIOₓ) with late transition metals (or early transition metals) interspersed within the matrix base (preferably noble metals) - though at lower oxygen concentrations, a metal silicide phase may exist as well.

In yet another example, the matrix material may be a ternary (or higher) material X-Y-Z, where X is a transition metal - preferably a late transition metal; Y is Si , Al or B; and Z is N (or O-N or C-N). Thus the material is viewed as comprising a nitride (or oxynitride or carbonitride) that forms an insulating matrix (e.g. silicon nitride, oxynitride or carbonitride), with small "bubbles" or particles or islands of *e.g*. a late transition metal interspersed throughout the matrix base. In one example, the late transition metal is a noble metal. In another example, the late transition metal is Co, Ni or Fe.

In yet another example, the thermal barrier (104) comprises a material having elements *XₐY_{b}Z_{c},* wherein *X* is a transition metal (*e.g*. early transition metal or late transition metal, such as Ir, Ru, Re, Pd, Pt, Rh or Co or Ti), *Y* is selected from column IIIA or IVA in the periodic table *e.g*. Si, B, Al, and Ge); and *Z* is selected from column VA or VIA in the periodic table (*e.g*. N and O). Exemplary *XₐY_{b}Z_{c}* material can be CoSiN and TiSiN.

In yet another example, thermal barrier 104 comprises an early transition metal nitride and another chemical element. Alternatively thermal barrier 104 may comprise a noble metal and oxygen; or thermal barrier 104 may comprise conductive metal oxide and a third element, such as Si or O. In other examples, different transition metals can be included in the thermal barrier (104).

It is noted that the above materials for the matrix base and the interspersing particles can be used as cermet materials for the thermal barrier but in any other forms other than matrix with interspersing particles. The above materials can be presented as chemical composites or other forms in the thermal barrier.

A thin-film layer of the above discussed cermet can be formed in many thin-film deposition techniques, such as physical-vapor-deposition (PVD), chemical-vapor-phase deposition (CVD), physically-energized-CVD (PECVD), LPCVD, and other methods. As an example, a transition metal nitride layer can be formed by sputtering a transition metal target (e.g. a single transition metal, more than one transition metal such as an alloy of two or more transition metals, or a transition metal compound (e.g. transition metal aluminide or preferably silicide) in nitrogen gas. Though the target could be a combination of more than one transition metal (or two transition metals in alloy form), in one example it is preferred that the target comprise a single transition metal, or one (or more) transition metals and one or more metalloids (and, perhaps, minute quantities of impurities such as O, H, other transition metals, metalloids, etc., which are often present in various sputtering methods). In one embodiment, the target comprises at least one transition metal and at least one metalloid. In another example, the target comprises a single transition metal without any other metals except as impurities or in trace amounts. In such a case, it is preferred that the transition metal of the target make up 90% or more of the target, preferably 98% or more. And, though nitrogen and argon are the preferred gases for reactive sputtering in the present invention (e.g. 20%N2, 80% Ar), small amounts of oxygen or hydrogen (or compounds thereof such as a transition metal oxide in small amounts) can be present in the layer or structure being formed (the oxygen and/or hydrogen in the layer coming from target "impurities" or from the sputtering gas.

The thermal barrier may be comprised of multiple layers, an example of which is diagrammatically illustrated in FIG. 2. Referring to FIG. 2, the barrier layer (104 or 114 in FIG. 1) is a laminate that comprises layer 118 that may be a transition nitride or oxide material layer with a thickness of from 1 to 100 nanometers, and more preferably around 20 nanometers. As an alternative feature, adhesion layers 116 and 120 can be deposited on the top and bottom surfaces of the intermediate layer 118 to enhance the adhesion of the intermediate layer (118) to other device layers, such as to the free magnetic layer (106), fixed magnetic layer (110), and/or buffer layer (112). Exemplary materials for the adhesion layers (116 and 120) can be TiWN₂.

Referring again to FIG. 1, the top and the bottom electrode layers 120a and 120b provide electrical contacts (electrodes), for example, to external signal/power sources. Accordingly, the electrode layers each comprise an electrically conductive material, such as metallic elements, metallic alloys, metallic compounds, inter-metallic compounds, and any combinations thereof. Each electrode layer can be a laminate comprising multiple layers of different materials. The intermetallic compound may be composed of an early transition metal or a late transition metal. In one example, the electrodes 102a and 102b may comprise NiFe, CoFe, CoNiFe, CoFeB, PtMn, Ru, IrMn, or other suitable materials. In another example, the electrodes 102a and 102b may be comprised of Ti, Ta, or a laminate of Ti and Ta.

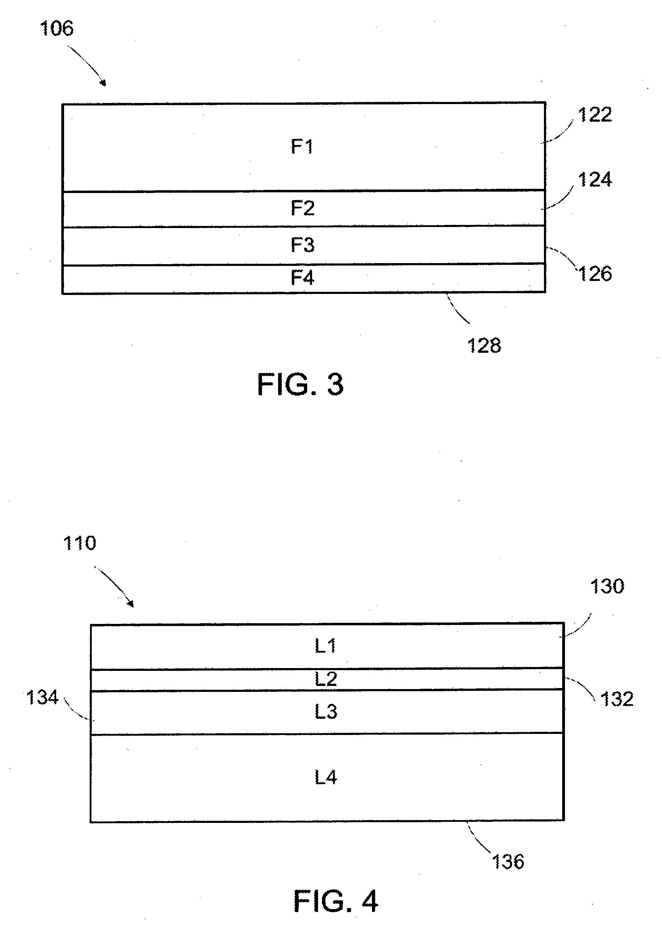

The free magnetic layer 106 is comprised of a magnetic material. In one example, the free magnetic layer 106 has a low blocking temperature, such as a blocking temperature of 200°C or lower, and more preferably around 150°C. The free magnetic layer may be comprised of multiple layers, such as pining layer 122 that may comprise IrMn or other chemical species, layer 124 that may be NiFe or other materials, and layer 126 that can be CoFeB or other materials as diagrammatically illustrated in FIG. 3. As an alternative feature, a Ta layer 128 can be included in the free magnetic layer stack so as to decouple the correlation between the dielectric layer (the tunnel junction layer 108 in FIG. 1) and the IrMn pining layer 122. The Ta layer (128) can be disposed at any locations between the IrMn layer 122 and the tunnel junction layer (108 in FIG. 2). For example, the Ta decoupling layer can be disposed between the NiFe and CoFeB layers, or between the IrMn and NiFe layers.

Dielectric layer (tunnel junction layer) 108 is the magnetic-tunnel-junction layer. The dielectric layer 108 may be comprised of various dielectric materials, such as oxides, nitrides, carbides, oxy-nitrides, carbon-oxy-nitrides, and other suitable materials and any combinations thereof. The dielectric layer can be a separate thin-film layer formed for example, by thin-film deposition followed by patterning. Alternatively, the dielectric layer can be formed by chemical reaction of another or other device components. For example, a metallic layer comprised of a metallic element, such as Mg or Al, can be deposited. The deposited metallic layer can be oxidized or nitridized so as to form the desired dielectric layer.

Fixed magnetic layer 110 is comprised of a magnetic material, such as a ferromagnetic, anti-ferromagnetic, and/or permanent magnetic materials. Regardless of different materials used, it is preferred (though not required) that the fixed magnetic layer has a higher blocking temperature than the free magnetic layer, such as a blocking temperature of 200°C or higher, and more preferably below 500°C, and more preferably around 325°C. The fixed magnetic layer (110) may alternatively be comprised of multiple thin-film components, an example of which is diagrammatically illustrated in FIG. 4. Referring to FIG. 4, the fixed magnetic layer 110 in this example comprises layer 130 that may comprise CoFeB or other materials, layer 132 that may comprise Ru or other materials, layer 134 that may comprise CoFe or other materials, and pining layer 136 that may comprise PtMn or other materials.

Referring back to FIG. 1, buffer layer 112 can be provided as an alternative feature. An exemplary buffer layer can be a Ta layer.

The thermally assisted magnetic tunnel junction 100 as discussed above can be configured as many electronic devices, such as signal storage devices (*e.g*. magnetic random-access memories), magnetic writing/reading heads, and sensors. In digital storage application, a bit value can be written to or read out from the magnetic junction structure 100 by the top and bottom electrodes 102a and 102b. Often times, a number of magnetic tunnel junction structures are arranged as a memory array for storing digital values.

In an embodiment not illustrated, a memory system comprises memory array with a plurality of the thermally assisted magnetic tunnel structure disclosed herein. The memory system can further comprise one or a plurality of current lines connecting the plurality of magnetic tunnel structure, for example along a row and/or a column, in order to pass the electrical current heating the thermal barrier 104, 114.

It will be appreciated by those of skill in the art that a new and useful thermally-assisted magnetic tunnel junction structure has been described herein. In view of the many possible embodiments, however, it should be recognized that the embodiments described herein with respect to the drawing figures are meant to be illustrative only and should not be taken as limiting the scope of what is claimed. Those of skill in the art will recognize that the illustrated embodiments can be modified in arrangement and detail. Therefore, the devices and methods as described herein contemplate all such embodiments as may come within the scope of the following claims and equivalents thereof.

## Claims

1. A magnetic-random-access memory device wherein writing is thermally-assisted, comprising:
a magnetic tunnel junction comprising a tunnel junction layer (108) positioned between a free magnetic layer (106) and a fixed magnetic layer (110); and
a thermal barrier (104, 114) **characterized in that** the thermal barrier pins the free magnetic layer (106) below a temperature threshold and acts as a paramagnet at and above the temperature threshold when the thermal barrier is heated during the thermally-assisted writing; the thermal barrier (104, 114) comprising a cermet material that is comprised of a ceramic and a metallic component.

2. The device according to claim 1, wherein
the cermet material is comprised of XₐY_{b}Z_{c}, wherein X is a transition metal, Y is selected from column IIIA or IVA in the periodic table; and wherein Z is selected from column VA or VIA in the periodic table.

3. The device according to claim 2, wherein Y is Si, B, Al, or Ge.

4. The device according to the claim 2 or 3, wherein Z is nitrogen or oxygen.

5. The device according to any one of the claims 2 to 4, wherein X is Ir, Ru, Re, Pd, Pt, Rh, Co, or Ti.

6. The device according to claim 1, wherein
the cermet material comprises a matrix base material with an interspersing material interspersed within or at a surface of the matrix base material.

7. The device according to claim 6, wherein
the interspersing material is comprised of a transition metal.

8. The device according to claim 6, wherein
the matrix base material is comprised of a binary compound *Y-Z,* wherein *Y* is selected from groups 3A to 6A of the periodic table and Z is N.

9. The device according to claim 6, wherein
the matrix base material is comprised of a nitride of silicon, aluminum or boron.

10. The device according to claim 8, wherein
the binary compound *Y-Z* is SiOₓ, BOₓ, POₓ, or AlOₓ.

11. The device according to claim 6, wherein
the matrix base material is comprised of a ternary material *X-Y-Z,* where *X* is a transition metal; *Y* is Si, Al, or B; and Z is nitride or O-N, or C-N, or P-N.

12. The device according to any one of the claims 1 to 11, wherein said metallic component has a long range order that is 200 angstroms or less in the thermal barrier.

13. The device according to any one of the claims 1 to 12, wherein the thermal barrier has a thermal conductivity of 3 W/mK or less.

14. The device according to any one of the claims 1 to 13, wherein the thermal barrier has an electrical conductivity of from 1x10⁴ S/m to 60×10⁴S/m at a temperature of 20°C.

15. A magnetic memory system comprising a plurality of the device **characterized by** any one of claims 1 to 14.

## Patentansprüche

1. Ein magnetisches Direktzugriffsspeichergerät, worin Schreiben thermisch unterstützt ist, aufweisend:
einen magnetischen Tunnelkontakt aufweisend eine Tunnelkontaktschicht (108), die zwischen einer freien magnetischen Schicht (106) und einer festen magnetischen Schicht (110) angeordnet ist; und
eine thermische Barriere (104, 114);
**dadurch gekennzeichnet, dass**
die thermische Barriere (104, 114) die freie magnetische Schicht (106) unter einem Temperaturschwellwert festhält und als Paramagnet bei und über dem Temperaturschwellwert fungiert, wenn die thermische Barriere (104, 114) während dem thermisch unterstützten Schreiben geheizt wird; wobei die thermische Barriere (104, 114) ein Cermetmaterial aufweist, das eine keramische und eine metallische Komponente aufweist.

2. Das Gerät nach Anspruch 1, wobei das Cermetmaterial XaYbZc aufweist, wobei X ein Übergangsmetall ist, Y ist aus der Spalte IIIA oder IVA des Periodensystems ist; und wobei Z aus der Spalte VA oder VIA des Periodensystems ausgewählt wird.

3. Das Gerät nach Anspruch 2, wobei Y Si, B, Al oder Ge ist.

4. Das Gerät nach Anspruch 2 oder 3, wobei Z ein Stickstoff oder Sauerstoff ist.

5. Das Gerät nach einem der Ansprüche 2 bis 4, wobei X Ir, Ru, Re, Pd, Pt, Rh, Co oder Ti ist.

6. Das Gerät nach Anspruch 1, wobei das Cermetmaterial ein Matrixgrundmaterial aufweist mit einem eingestreuten Material eingestreut in das Matrixgrundmaterial oder auf eine Oberfläche des Matrixgrundmaterials.

7. Das Gerät nach Anspruch 6, wobei das eingestreute Material ein Übergangsmetall aufweist.

8. Das Gerät nach Anspruch 6, wobei das Matrixgrundmaterial einen binären Verbund Y-Z aufweist, wobei Y aus der Spalte 3A bis 6A des Periodensystems ausgewählt ist und Z N ist.

9. Das Gerät nach Anspruch 6, wobei das Matrixgrundmaterial ein Nitrid von Silizium, Aluminium oder Bor ist.

10. Das Gerät nach Anspruch 8, wobei der binäre Verbund Y-Z SOₓ, BOₓ, POₓ oder AlOₓ ist.

11. Das Gerät nach Anspruch 6, wobei das Matrixgrundmaterial ein aus drei Teilen bestehendes Material X-Y-Z aufweist, wobei X ein Übergangsmetall ist; Y Si, Al oder B ist; und Z ein Nitrid oder O-N oder C-N oder P-N ist.

12. Das Gerät nach einem der Ansprüche 1 bis 11, wobei die metallische Komponente eine Fernordnung, die 200 Angstroms oder weniger ist, in der thermischen Barriere hat.

13. Das Gerät nach einem der Ansprüche 1 bis 12, wobei die thermische Barriere eine thermische Leitfähigkeit von 3 W/mK oder weniger hat.

14. Das Gerät nach einem der Ansprüche 1 bis 13, wobei die thermische Barriere eine elektrische Leitfähigkeit von 1 × 10⁴ S/m bis 60 × 10⁴ S/m bei einer Temperatur von 20° C hat.

15. Ein magnetisches Speichersystem aufweisend eine Vielzahl von Geräten **gekennzeichnet durch** einen der Ansprüche 1 bis 14.

## Revendications

1. Un dispositif de mémoire magnétique à accès aléatoire, dans lequel la procédure d'écriture est thermiquement assistée, comprenant:
une jonction tunnel magnétique comprenant une couche de jonction tunnel (108) positionnée entre une couche magnétique libre (106) et une couche magnétique fixe (110) ; et
une barrière thermique (104, 114) **caractérisée en ce que** la barrière thermique maintient la couche magnétique libre (106) en-dessous d'un seuil thermique et agit comme un élément paramagnétique au seuil de température et en-dessus du seuil de température lorsque la barrière thermique est chauffée pendant l'opération d'écriture thermiquement assistée ; la barrière thermique (104, 114) comprenant un matériau cermet qui consiste en un composant céramique et un composant métallique.

2. Le dispositif selon la revendication 1, dans lequel
le matériau cermet est constitué de XₐY_{b}Z_{c}, dans lequel X est un métal de transition, Y est sélectionné parmi la colonne IIIA ou IVA dans le tableau périodique des éléments ; et où Z est choisi dans la colonne VA ou VIA dans le tableau périodique.

3. Le dispositif selon la revendication 2, dans lequel Y est Si, B, Al ou Ge.

4. Le dispositif selon la revendication 2 ou 3, dans lequel Z est l'azote ou l'oxygène.

5. Le dispositif selon l'une quelconque des revendications 2 à 4, dans lequel X est Ir, Ru, Re, Pd, Pt, Rh, Co ou Ti.

6. Le dispositif selon la revendication 1, dans lequel le matériau cermet comprend un matériau matriciel de base avec un matériau de dissémination disséminé au sein de ou à la surface du matériau matriciel de base.

7. Le dispositif selon la revendication 6, dans lequel le matériau de dissémination est constitué d'un métal de transition.

8. Le dispositif selon la revendication 6, dans lequel le matériau matriciel de base est constitué d'un composé binaire Y-Z, dans lequel Y est sélectionné parmi les groupes 3A à 6A du tableau périodique et Z est N.

9. Le dispositif selon la revendication 6, dans lequel le matériau matriciel de base est constitué de nitrure de silicium, aluminium ou bore.

10. Le dispositif selon la revendication 8, dans lequel le composé binaire Y-Z est SiOₓ, BOₓ, POₓ ou AlOₓ.

11. Le dispositif selon la revendication 6, dans lequel le matériau matriciel de base est constitué d'un matériau ternaire X-Y-Z, où X est un métal de transition ; Y est Si, Al ou B ; et Z est un nitrure ou O-N, ou C-N, ou P-N.

12. Le dispositif selon l'une quelconque des revendication 1 à 11, dans lequel ledit composant métallique a un ordre à longue portée qui est de 200 angströms ou moins dans la barrière thermique.

13. Le dispositif selon l'une quelconque des revendications 1 à 12, dans lequel la barrière thermique a une conductivité thermique de 3W/mK ou moins.

14. Le dispositif selon l'une quelconque des revendications 1 à 13, dans lequel la barrière thermique a une conductivité électrique de 1x10⁴ s/m à 60x10⁴ s/m à une température de 20°C.

15. Un système de mémoire magnétique comprenant une pluralité de dispositifs **caractérisés par** l'une quelconque des revendications 1 à 14.
